# EUROPEAN PATENT APPLICATION

(11) **EP 2 151 308 A1**
(43) Date of publication of application: **10.02.2010**
(21) Application number: 09166548.9
(22) Date of filing: 28.07.2009
(51) Int. Cl.: B29C 45/14

(54) **Housing and manufacturing method thereof**

(30) Priority: 07.08.2008 CN 200810303569
(71) Applicant: Shenzhen Futaihong Precision Industry Co., Ltd., Shenzhen City, Guangdong Province 518109 (CN); FIH (Hong Kong) Limited, Cheng Sha Wan Kowloon Hong Kong (CN)
(72) Inventor: Zhang, Bing, BaoAn District 518109, Shenzhen City Guangdong 518109 (CN); Zeng, Yi-Ping, BaoAn District 518109, Shenzhen City Guangdong 518109 (CN)
(74) Representative: Craven, Ian

(57) **Abstract**

A housing, comprising: a transparent substrate; a decorative coating formed on one surface of the substrate, the decorative coating having a pattern defined therethrough; a protective coating formed on the decorative coating; and a colorized ink coating formed on the other surface of the substrate opposite to the decorative coating and visible through the pattern in the decorative coating. A method for making the housing is also described.

## Description

The present invention relates to housings, especially to a housing having a pattern not easily abraded and a manufacturing method thereof.

Housings of portable electronic devices are commonly made of plastic. These plastic housings may be coated with paint or ink to provide a decorative appearance. A symbolical pattern is usually printed over the paint or ink coating to form a logo of the device. The pattern formed on the surface of the paint or ink coating has a poor adhesion to the coating, and is prone to abrasion which affects the appearance of the housing.

To prevent the pattern from abrasion, a transparent protective ink coating is typically printed on the symbolical pattern. However, the protective ink coating formed on the pattern may also be abraded over time. Thus, the protective ink coating has a poor protective effect to the pattern. In addition, the protective ink coating may cause unaesthetic appearance of the housing.

Therefore, there is room for improvement within the art.

### BRIEF DESCRIPTION OF THE DRAWINGS

Many aspects of the housing with a pattern which would not be abraded can be better understood with reference to the following drawings. The components in the drawings are not necessarily drawn to scale, the emphasis instead being placed upon clearly illustrating the principles of the housing with a pattern which would not be abraded. Moreover, in the drawing like reference numerals designate corresponding parts throughout the several views.

FIG. 1 is a cross-sectional view of a present embodiment of a housing with a pattern which would not be abraded.

FIG. 2 is a flow chart of a present embodiment of a method for making the housing shown in FIG.1.

### DETAILED DESCRIPTION OF THE DISCLOSURE

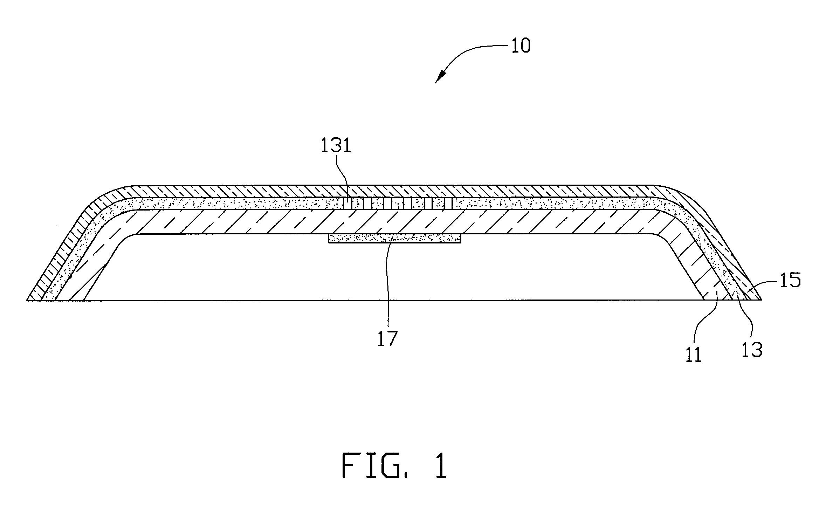

Referring to FIG. 1, in a present exemplary embodiment, a housing 10 includes a substrate 11, a decorative coating 13 formed on one surface of the substrate 11, and a protective coating 15 formed on the decorative coating 13.

The substrate 11 is made of transparent plastic selected from a group consisting of polyethylene (PE), polyamide (PA), polycarbonate (PC), acrylonitrile-butadiene-styrene (ABS), polymethyl methacrylate (PMMA), and polyethylene terephthalate (PET). A colorized ink coating 17 is printed on the other surface of the substrate 11 opposite to the surface of formed with the decorative coating 13. The colorized ink coating 17 may be formed on partial or whole surface of the substrate 11.

The decorative coating 13 is a colorized paint coating formed by painting. A pattern 131 is formed on the decorative coating 13 by laser etching. The pattern 131 is formed in partial region of the decorative coating 13, and opposite to the colorized ink coating 17. The etching allows the colorized ink coating 17 to be visual through the colorized paint of the decorative coating 13 and the clear protective coating 15 and substrate 11.

The protective coating 15 is a transparent paint coating formed by painting. The protective coating 15 can prevent the decorative coating 13 from abrasion while maintaining its colorful appearance.

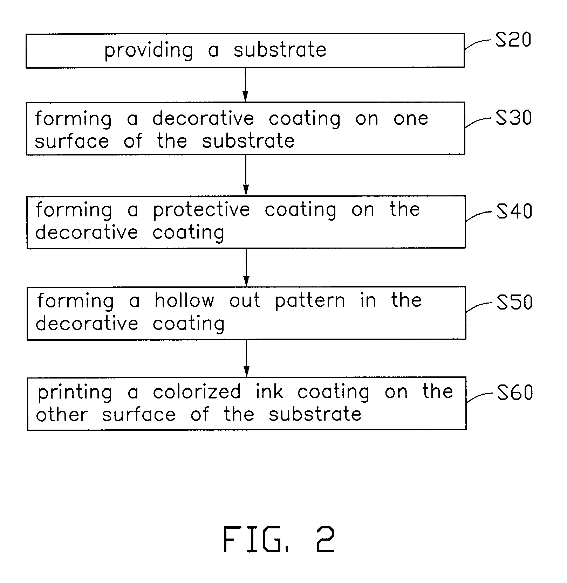

A method for making the housing 10 is provided. Referring to FIG. 2, the method may comprise the steps S20 to steps S60. In step S20, a substrate 11 made of transparent plastic selected from a group consisting of polyethylene (PE), polyamide (PA), polycarbonate (PC), acrylonitrile-butadiene-styrene (ABS), polymethyl methacrylate (PMMA), and polyethylene terephthalate (PET) is provided.

In step S30, a decorative coating 13 is formed on one surface of the substrate 11. The decorative coating 13 may be a color painting coating formed by painting.

In step S40, a protective coating 15 is formed on the decorative coating 13. The protective coating 15 may be a transparent painting coating formed by painting.

In step S50, a pattern 131 is formed through in the decorative coating 13 by etching. The etching step is carried out by using a laser beam.

In step S60, a colorized ink coating 17 is printed on the other surface of the substrate 11. The colorized ink coating 17 may be formed on the whole surface of the substrate 11, or partial region of the surface opposite to the pattern 131. The etching step allows the colorized ink coating 17 to be visual through the colorized paint of the decorative coating 13 and the clear protective coating 15 and substrate 11. The color of the colorized ink coating 17 is different form the decorative coating 13, and can be changed to satisfy different pattern appearance required of the housing 10.

The housing 10 is formed with a pattern 131 through in the decorative coating 13 set between the substrate 11 and the protective coating 15, which can better protect the pattern 131 from abrasion. A colorized ink coating 17 is printed on the other surface of the substrate 11 opposite to the pattern 131 to provide colorful appearance to the pattern 131. In addition, the pattern 131 can present a three dimensional vision. The method of making the housing 10 utilizes laser to etch the decorative coating 13 to form the pattern 131, which has a higher efficiency at recomposing the pattern 131 depending on the product design requirements and avoid of making different printing halftones to print patterns.

The housing 10 disclosed in the present disclosure may be a housing of a mobile phone, a game player, or a camera. The housing 10 may also be a container or a cover of a container.

It should be understood, however, that even though numerous characteristics and advantages of the present embodiments have been set forth in the foregoing description, together with details of functions of the embodiments, the disclosure is illustrative only, and changes may be made in detail within the principles of the invention to the full extent indicated by the broad general meaning of the terms in which the appended claims are expressed.

## Claims

1. A housing, comprising:
a transparent substrate;
a decorative coating formed on one surface of the substrate, the decorative coating having a pattern defined therethrough;
a protective coating formed on the decorative coating; and
a colorized ink coating formed on the other surface of the substrate opposite to the decorative coating and visible through the pattern in the decorative coating.

2. The housing as claimed in claim 1, wherein the substrate is made of transparent plastic selected from a group consisting of polyethylene, polyamide, polycarbonate, acrylonitrile-butadiene-styrene, polymethyl methacrylate, and polyethylene terephthalate.

3. The housing as claimed in claim 1, wherein the decorative coating is a colorized painting coating, and the protective coating is a transparent painting coating.

4. The housing as claimed in claim 1, wherein the pattern is formed by etching through the decorative coating using laser beam.

5. The housing as claimed in claim 4, wherein the colorized ink coating is printed on partial region of the surface of the substrate opposite to the pattern.

6. A method for making a housing, comprising:
providing a transparent substrate;
forming a decorative coating on one surface of the substrate;
forming a protective coating on the decorative coating;
forming a pattern in the decorative coating; and
printing a colorized ink coating on the other surface of the substrate opposite to the decorative coating.

7. The method as claimed in claim 6, wherein the substrate is made of transparent plastic selected from a group consisting of polyethylene, polyamide, polycarbonate, acrylonitrile-butadiene-styrene, polymethyl methacrylate, and polyethylene terephthalate.

8. The method as claimed in claim 6, wherein the decorative coating is a colorized painting coating, and the protective coating is a transparent painting coating.

9. The method as claimed in claim 6, wherein the pattern is formed by etching through the decorative coating using laser beam.

10. The method as claimed in claim 9, wherein the colorized ink coating is printed on partial region of the surface of the substrate opposite to the pattern.
